# EUROPEAN PATENT APPLICATION

(11) **EP 4 668 015 A2**
(43) Date of publication of application: **24.12.2025**
(21) Application number: 25183451.1
(22) Date of filing: 17.06.2025
(51) Int. Cl.: G03F 1/22, G03F 1/42, G03F 1/84

(54) **REFLECTIVE MASK BLANK AND METHOD FOR MANUFACTURING THE SAME, AND METHOD FOR INSPECTING REFLECTIVE MASK BLANK-RELATED SUBSTRATE**

(30) Priority: 20.06.2024 JP 2024100014; 02.04.2025 JP 2025061269
(71) Applicant: Shin-Etsu Chemical Co., Ltd., Tokyo 100-0005 (JP)
(72) Inventor: TAKEDA, Atsuhiro, Niigata (JP); MUNEYASU, Riku, Niigata (JP)
(74) Representative: Schicker, Silvia

(57) **Abstract**

A reflective mask blank in which a reference mark can be reliably detected without erroneously detecting a defect as the reference mark, and a method for manufacturing the same, and a method for inspecting a reflective mask blank-related substrate are provided. The reflective mask blank includes at least: a substrate; a multilayer reflective film provided on the substrate and reflecting exposure light; and an absorber film provided on the multilayer reflective film and absorbing the exposure light, the reflective mask blank further including a reference mark serving as a reference position for a defect position and a reference mark forming region for searching for the reference mark, which are formed on a surface on a same side as the multilayer reflective film of the reflective mask blank, the reference mark forming region being formed at a different height from surroundings of the reference mark forming region, the reference mark being formed such that at least a part of the reference mark is included in the reference mark forming region.

## Description

### TECHNICAL FIELD

The present invention relates to a reflective mask blank used in semiconductor device manufacturing and the like and a method for manufacturing the same, and a method for inspecting a reflective mask blank-related substrate.

### BACKGROUND ART

In the manufacturing process of semiconductor devices (semiconductor apparatuses), photolithography technology to irradiate a transfer mask with exposure light and transfer a circuit pattern formed on the mask onto a semiconductor substrate (semiconductor wafer) via a reduction projection optical system is used repeatedly. Conventionally, a wavelength of the exposure light has been mainly 193 nm using argon fluoride (ArF) excimer laser light, and by adopting a process called multi-patterning which combines an exposure process and a processing process a plurality of times, patterns with dimensions smaller than the exposure wavelength have been ultimately formed.

However, as device patterns continue to become finer, formation of even finer patterns is required, and therefore extreme ultraviolet (hereinafter, referred to as "EUV") lithography technology, which uses EUV light with an even shorter wavelength than ArF excimer laser light as exposure light has begun to be used. EUV light is light with a wavelength of about 0.2 to 100 nm, and more specifically light with a wavelength in a vicinity of 13.5 nm. Since the EUV light has extremely low transmittance to materials, and conventional transmission type projection optical systems and masks cannot be used, reflection type optical elements are used. In addition, as for the mask for pattern transfer, reflective masks are also proposed.

A reflective mask is such that a multilayer reflective film that reflects EUV light is formed on the substrate, and an absorber film that absorbs the EUV light is formed in a pattern form on the multilayer reflective film (hereinafter, this will be referred to as an EUV reflective mask). On the other hand, what is in a state before patterning on the absorber film (including a state in which a resist film is formed) is called a reflective mask blank, and this is used as a raw material of the reflective mask (hereinafter, this will be referred to as an EUV reflective mask blank).

In an EUV reflective mask, if there is a defect in a recessed or protruded shape in the surface layer thereof or in the film, the reflectance of the EUV light is reduced in a defect portion, and it is impossible to obtain a desired transfer pattern during wafer exposure. In particular, if a defect exists in the multilayer reflective film, or between the multilayer reflective film and the substrate, even if the defect is only a few nm in height, a phase shift of the reflection light of the EUV light occurs around it due to collapse of the periodic structure of the multilayer reflective film, which causes local reduction in reflectance. This has a particularly large effect on the pattern shape transferred to the wafer. The defect like this is called a phase defect. A phase defect is difficult to correct because it is located in or under the film. On the other hand, defects that exist on the multilayer reflective film and on the absorber film attenuate the intensity of the reflection light of the EUV light, and thus they are called amplitude defects in contrast to phase defects.

In order to avoid the effect on the transfer pattern by the phase defect and the amplitude effect, defect mitigation (hereinafter, referred to as a DM technology) that covers up phase defects with absorber patterns is proposed. In the DM technology, it is realized by obtaining defect position information on the EUV reflective mask blank in the coordinate system in mask manufacturing by identifying the defect position in the coordinate system defined by a reference mark produced on the EUV reflective mask blank by defect inspection, measuring a reference mark position in a mask manufacturing process, and performing a proper coordinate conversion.

### CITATION LIST

### PATENT LITERATURE

Patent Document 1: JP 2017-227936 A

### SUMMARY OF INVENTION

### TECHNICAL PROBLEM

Patent Document 1 describes formation of a reference mark characterized by having a symmetrical shape, and a portion with a width of 200 nm or more and 10 µm or less with respect to a scanning direction of an electron beam or defect inspection light, as the reference mark. When detecting the reference mark, for example, a method can be considered, in which a region around design coordinates of the reference mark is searched by a defect inspection machine, and an object whose area is within a certain range is recognized as the reference mark, but the size of the reference mark proposed in Patent Document 1 is approximately the same as a defect that can exist on the reflective mask blank, and there is a problem that when such a defect exists around the reference mark, the defect will be erroneously detected as the reference mark. In such a case, the defect position in the coordinate system defined by the reference mark cannot be properly obtained, which brings about a situation in which the DM technology cannot be applied in the manufacturing process of reflective masks.

The present invention, which has been made to solve the above-described problem, aims to provide a reflective mask blank, in which a reference mark can be reliably detected without erroneously detecting a defect as the reference mark, and a method for manufacturing the same, and a method for inspecting a reflective mask blank-related substrate.

### SOLUTION TO PROBLEM

To achieve the object, the present invention provides
a reflective mask blank including at least:
a substrate;
a multilayer reflective film provided on the substrate, the multilayer reflective film reflecting exposure light; and
an absorber film provided on the multilayer reflective film, the absorber film absorbing the exposure light,
the reflective mask blank further including:
   a reference mark serving as a reference position for a defect position; and a reference mark forming region for searching for the reference mark, the reference mark and the reference mark forming region being formed on a surface on a same side as the multilayer reflective film of the reflective mask blank,
   the reference mark forming region being formed at a different height from surroundings of the reference mark forming region,
   the reference mark being formed such that at least a part of the reference mark is included in the reference mark forming region.

With the reflective mask blank of the present invention, a defect and the reference mark can be distinguished based on presence or absence of the reference mark forming region during search for the reference mark by a defect inspection machine. Accordingly, it is possible to provide the reflective mask blank in which the reference mark can be reliably detected without erroneously detecting a defect as the reference mark. Therefore, it is possible to identify the defect position properly based on the detected reference mark.

Furthermore, to achieve the object, the present invention provides
a reflective mask blank including at least:
a substrate;
a multilayer reflective film provided on the substrate, the multilayer reflective film reflecting exposure light; and
an absorber film provided on the multilayer reflective film, the absorber film absorbing the exposure light,
the reflective mask blank further including:
   a reference mark serving as a reference position for a defect position; and a reference mark forming region for searching for the reference mark, the reference mark and the reference mark forming region being formed on a surface on a same side as the multilayer reflective film of the reflective mask blank,
   the reference mark forming region being formed at a different height from a main pattern forming region,
   the reference mark being formed such that at least a part of the reference mark is included in the reference mark forming region.

With the reflective mask blank of the present invention, a defect and the reference mark can be distinguished based on presence or absence of the reference mark forming region during search for the reference mark by a defect inspection machine. Accordingly, it is possible to provide the reflective mask blank in which the reference mark can be reliably detected without erroneously detecting a defect as the reference mark. Therefore, it is possible to identify the defect position properly based on the detected reference mark.

Note that the main pattern forming region is a forming region of a mask pattern.

At this time, an absolute value of a height difference between the reference mark forming region and the main pattern forming region can be 1 nm or more.

With this, it is possible to more reliably provide contrast with the surroundings (main pattern forming region), during search for the reference mark by the defect inspection machine. As a result, it becomes easier to determine whether the reference mark forming region is present or absent.

Furthermore, the reference mark forming region can be smaller than a field of view of an optical image obtained by a defect inspection machine used during search for the reference mark.

With this, it is possible to more reliably display a boundary of the reference mark forming region within the field of view of the above-described optical image, and it becomes much easier to determine presence or absence thereof, during the search for the reference mark by the defect inspection machine.

Furthermore, the present invention provides
a method for manufacturing a reflective mask blank, including at least steps of:
forming a multilayer reflective film on a substrate, the multilayer reflective film reflecting exposure light; and
forming an absorber film on the multilayer reflective film, the absorber film absorbing the exposure light;
the method further including
a step of forming a reference mark and a reference mark forming region on a surface on a same side as the multilayer reflective film of the reflective mask blank, the reference mark serving as a reference position for a defect position, the reference mark forming region being for searching for the reference mark,
wherein in the step of forming the reference mark and the reference mark forming region,
the reference mark forming region is formed to have a different height from surroundings of the reference mark forming region, and
the reference mark is formed such that at least a part of the reference mark is included in the reference mark forming region.

With the method for manufacturing a reflective mask blank of the present invention, it is possible to provide a reflective mask blank in which a reference mark can be reliably detected without erroneously detecting a defect as the reference mark. The reason why the above-described erroneous detection can be prevented is that the defect and the reference mark can be distinguished based on presence or absence of the reference mark forming region formed on the reflective mask blank during search for the reference mark by a defect inspection machine. Then, the defect position can be properly identified based on the detected reference mark.

Furthermore, the present invention provides
a method for manufacturing a reflective mask blank, including at least steps of:
forming a multilayer reflective film on a substrate, the multilayer reflective film reflecting exposure light; and
forming an absorber film on the multilayer reflective film, the absorber film absorbing the exposure light,
the method further including
a step of forming a reference mark and a reference mark forming region on a surface on a same side as the multilayer reflective film of the reflective mask blank, the reference mark serving as a reference position for a defect position, the reference mark forming region being for searching for the reference mark,
wherein in the step of forming the reference mark and the reference mark forming region,
the reference mark forming region is formed to have a different height from a main pattern forming region, and
the reference mark is formed such that at least a part of the reference mark is included in the reference mark forming region.

With the method for manufacturing a reflective mask blank of the present invention, it is possible to provide a reflective mask blank in which a reference mark can be reliably detected without erroneously detecting a defect as the reference mark. The reason why the above-described erroneous detection can be prevented is that the defect and the reference mark can be distinguished based on presence or absence of the reference mark forming region formed on the reflective mask blank during search for the reference mark by a defect inspection machine. Then, the defect position can be properly identified based on the detected reference mark.

At this time, in the step of forming the reference mark and the reference mark forming region,
the reference mark forming region can be formed such that an absolute value of a height difference between the reference mark forming region and the main pattern forming region is 1 nm or more.

In doing so, it is possible to more reliably provide contrast with the surroundings (main pattern forming region) during the search for the reference mark by a defect inspection machine. Consequently, it becomes much easier to determine presence or absence of the reference mark forming region.

Furthermore, in the step of forming the reference mark and the reference mark forming region,
the reference mark forming region can be formed to be smaller than a field of view of an optical image obtained by a defect inspection machine used during search for the reference mark.

In doing so, it is possible to more reliably display a boundary of the reference mark forming region within the field of view of the above-described optical image, and it becomes easier to determine presence or absence thereof, during the search for the reference mark by the defect inspection machine.

Furthermore, when forming the reference mark and the reference mark forming region, the reference mark and the reference mark forming region can be formed by FIB processing.

In doing so, it is possible to form the reference mark and the reference mark forming region with high precision.

Furthermore, the present invention provides
a method for inspecting a reflective mask blank-related substrate, the reflective mask blank-related substrate being selected from a reflective mask blank and a manufacturing intermediate of the reflective mask blank, the reflective mask blank including at least:
a substrate;
a multilayer reflective film provided on the substrate, the multilayer reflective film reflecting exposure light; and
an absorber film provided on the multilayer reflective film, the absorber film absorbing the exposure light,
the method including:
   an inspection object preparation step of preparing the reflective mask blank-related substrate to be inspected; and
   an inspection step including search for a reference mark formed on the prepared reflective mask blank-related substrate, and identification of a defect position based on the reference mark,
   wherein in the inspection object preparation step,
   as the reflective mask blank-related substrate to be inspected, a reflective mask blank-related substrate is prepared, the reflective mask blank-related substrate including the reference mark and a reference mark forming region, the reference mark serving as a reference position for the defect position, the reference mark forming region being for searching for the reference mark, the reference mark and the reference mark forming region being formed on a surface on a same side as the multilayer reflective film of the reflective mask blank,
   the reference mark forming region being formed at a different height from surroundings of the reference mark forming region,
   the reference mark being formed such that at least a part of the reference mark is included in the reference mark forming region, and
   wherein in the inspection step,
   during the search for the reference mark, the reference mark and a defect are distinguished based on presence or absence of the reference mark forming region.

With the method for inspecting a reflective mask blank-related substrate of the present invention, in the inspection step, it is possible to reliably detect the reference mark without erroneously detecting a defect as the reference mark, and it is possible to properly identify a defect position based on the detected reference mark.

Furthermore, the present invention provides
a method for inspecting a reflective mask blank-related substrate, the reflective mask blank-related substrate being selected from a reflective mask blank and a manufacturing intermediate of the reflective mask blank, the reflective mask blank including at least:
a substrate;
a multilayer reflective film provided on the substrate, the multilayer reflective film reflecting exposure light; and
an absorber film provided on the multilayer reflective film, the absorber film absorbing the exposure light,
the method including:
   an inspection object preparation step of preparing the reflective mask blank-related substrate to be inspected; and
   an inspection step including search for a reference mark formed on the prepared reflective mask blank-related substrate, and identification of a defect position based on the reference mark,
   wherein in the inspection object preparation step,
   as the reflective mask blank-related substrate to be inspected, a reflective mask blank-related substrate is prepared, the reflective mask blank-related substrate including the reference mark and a reference mark forming region, the reference mark serving as a reference position for the defect position, the reference mark forming region being for searching for the reference mark, the reference mark and the reference mark forming region being formed on a surface on a same side as the multilayer reflective film of the reflective mask blank,
   the reference mark forming region being formed at a different height from a main pattern forming region,
   the reference mark being formed such that at least a part of the reference mark is included in the reference mark forming region, and
   wherein in the inspection step,
   during the search for the reference mark, the reference mark and a defect are distinguished based on presence or absence of the reference mark forming region.

With the method for inspecting a reflective mask blank-related substrate of the present invention, in the inspection step, it is possible to reliably detect the reference mark without erroneously detecting a defect as the reference mark and it is possible to properly identify the defect position based on the detected reference mark.

### ADVANTAGEOUS EFFECTS OF INVENTION

According to the reflective mask blank and the method for manufacturing the same, and the method for inspecting a reflective mask blank-related substrate of the present invention, even if a defect that can exist on the reflective mask blank and the reference mark have about the same sizes, it is possible to distinguish the reference mark and the defect based on the presence or absence of the reference mark forming region during search for the reference mark, and it is possible to provide the reflective mask blank in which the reference mark can be reliably detected without erroneously detecting the defect as the reference mark, and thus the defect position can be reliably and properly identified.

### BRIEF DESCRIPTION OF DRAWINGS

FIG. 1 is an example of a schematic sectional view of a case in which a reference mark forming region is in a recessed shape, in a reflective mask blank of the present invention;
FIG. 2 is an example of a schematic sectional view of a case in which the reference mark forming region is in a protruded shape, in the reflective mask blank of the present invention;
FIG. 3 is a schematic plan view showing a disposition example of a reference mark and the reference mark forming region on the reflective mask blank in the present invention;
FIG. 4 is a schematic plan view showing an example of a mutual positional relationship of the reference mark and the reference mark forming region in the present invention; and
FIG. 5 is an example of a schematic view of a shape in plan view of the reference mark in the present invention.

### DESCRIPTION OF EMBODIMENT

As described above, in the reference marks of the reflective mask blanks, there has been a demand for establishing a technology capable of reliably detecting the reference marks without erroneously detecting defects as the reference marks during search for the reference marks.

Thus, when the present inventor has conducted extensive research into reflective mask blanks, the present inventor has accomplished the present invention by finding that, as a reflective mask blank in which a defect and a reference mark are distinguished based on presence or absence of a reference mark forming region and the reference mark can be reliably detected without erroneously detecting a defect as the reference mark in reference mark search by a defect inspection machine or the like, it is possible to adopt a reflective mask blank (including at least a multilayer reflective film and an absorber film on a substrate) including a reference mark serving as a reference position for a defect position and a reference mark forming region for searching for the reference mark, the reference mark and the reference mark forming region being formed on a surface on a same side as the multilayer reflective film, the reference mark forming region being formed at a different height from surroundings of the reference mark forming region, the reference mark being formed such that at least a part of the reference mark is included in the reference mark forming region.

Further, in a method for manufacturing the reflective mask blank, the present inventor has accomplished the present invention by finding that it is possible to manufacture the reflective mask blank with a reference mark, which can reduce a risk of erroneously detecting a defect existing around the reference mark as the reference mark, by having steps of forming a multilayer reflective film and forming an absorber film, and further having a step of forming the reference mark and the reference mark forming region on a surface on a same side as the multilayer reflective film of the reflective mask blank, in which in the step of forming the reference mark and the reference mark forming region, the reference mark forming region is formed to have a different height from surroundings of the reference mark forming region, and the reference mark is formed such that at least a part of the reference mark is included in the reference mark forming region.

Furthermore, in a method for inspecting a reflective mask blank-related substrate (selected from the above-described reflective mask blank, and a manufacturing intermediate thereof), the present inventor has accomplished the present invention by finding that it is possible to reliably detect a reference mark without erroneously detecting a defect as the reference mark by preparing, in an inspection object preparation step and as a reflective mask blank-related substrate to be inspected, a reflective mask blank-related substrate including a reference mark and a reference mark forming region, the reference mark serving as a reference position for a defect position, the reference mark forming region being for searching for the reference mark, the reference mark and the reference mark forming region being formed on a surface on a same side as a multilayer reflective film of a reflective mask blank, the reference mark forming region being formed at a different height from surroundings of the reference mark forming region, the reference mark being formed such that at least a part of the reference mark is included in the reference mark forming region, and by distinguishing, in an inspection step, the reference mark and a defect based on presence or absence of the reference mark forming region, during search for the reference mark.

Furthermore, as one aspect of the reflective mask blank of the above-described present invention, the present inventor has accomplished the present invention by finding that, as a reflective mask blank in which a defect and a reference mark are distinguished based on presence or absence of a reference mark forming region and the reference mark can be reliably detected without erroneously detecting a defect as the reference mark in reference mark search by a defect inspection machine or the like, it is possible to adopt a reflective mask blank (including at least a multilayer reflective film and an absorber film on a substrate) including a reference mark serving as a reference position for a defect position and a reference mark forming region for searching for the reference mark, the reference mark and the reference mark forming region being formed on a surface on a same side as the multilayer reflective film, the reference mark forming region being formed at a different height from a main pattern forming region, the reference mark being formed such that at least a part of the reference mark is included in the reference mark forming region.

Further, in a method for manufacturing the reflective mask blank, the present inventor has accomplished the present invention by finding that it is possible to manufacture a reflective mask blank with a reference mark, which can reduce a risk of erroneously detecting a defect existing around the reference mark as the reference mark, by having steps of forming a multilayer reflective film and forming an absorber film, and further having a step of forming a reference mark and a reference mark forming region on a surface on a same side as the multilayer reflective film of the reflective mask blank, in which in the step of forming the reference mark and the reference mark forming region, the reference mark forming region is formed to have a different height from a main pattern forming region, and the reference mark is formed such that at least a part of the reference mark is included in the reference mark forming region.

Furthermore, in a method for inspecting a reflective mask blank-related substrate (selected from the above-described reflective mask blank, and a manufacturing intermediate thereof), the present inventor has accomplished the present invention by finding that it is possible to reliably detect a reference mark without erroneously detecting a defect as the reference mark by preparing, in an inspection object preparation step and as a reflective mask blank-related substrate to be inspected, a reflective mask blank-related substrate including a reference mark and a reference mark forming region, the reference mark serving as a reference position for a defect position, the reference mark forming region being for searching for the reference mark, the reference mark and the reference mark forming region being formed on a surface on a same side as a multilayer reflective film of a reflective mask blank, the reference mark forming region being formed at a different height from a main pattern forming region, the reference mark being formed such that at least a part of the reference mark is included in the reference mark forming region, and by distinguishing, in an inspection step, the reference mark and a defect based on presence or absence of the reference mark forming region, during search for the reference mark.

Hereinafter, an embodiment of the present invention will be described with reference to the drawings, but the present invention is not limited to this.

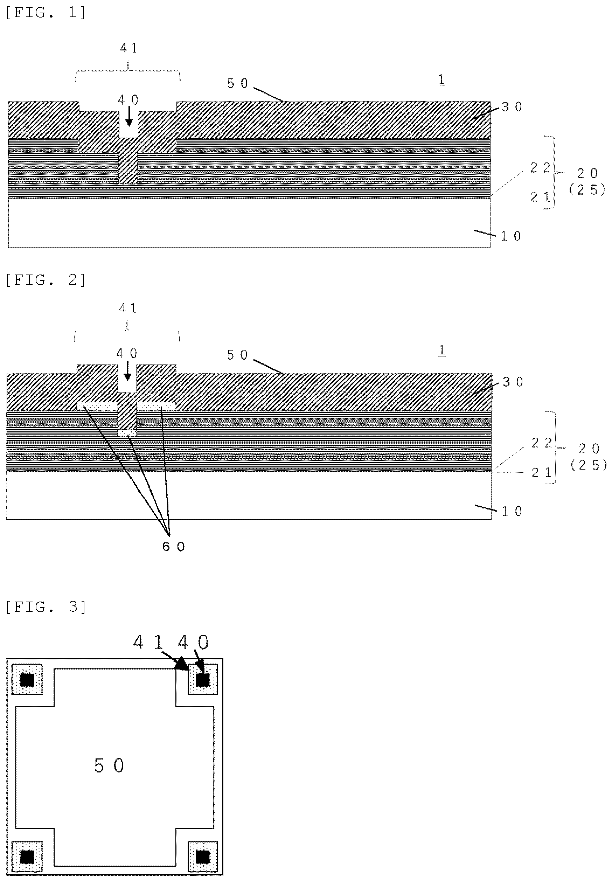

First, a reflective mask blank of the present invention will be described. FIGS. 1 and 2 show an example of a schematic view of the reflective mask blank according to the present invention. FIG. 1 is a mode in which a reference mark forming region is in a recessed shape, and FIG. 2 is a mode in which the reference mark forming region is in a protruded shape. The reflective mask blank for EUV is described as an example, but the present invention is not limited to this. In FIGS. 1 and 2, a reflective mask blank 1 first has a substrate 10, a multilayer reflective film 20 that is formed on a surface of the substrate 10 and reflects exposure light, an absorber film 30 that is formed on the multilayer reflective film 20 and absorbs exposure light, a reference mark 40 (serving as a reference position for a defect position) formed on a surface of the reflective mask blank, and a reference mark forming region 41 (including at least a part of the reference mark 40) formed around the reference mark 40.

Here, the reference mark forming region 41 is formed at a different height from surroundings of the reference mark forming region 41. A specific example of the "surroundings of the reference mark forming region 41" is not particularly limited, and, for example, a main pattern forming region 50 is cited. Hereinafter, in explanation of the reflective mask blank, a method for manufacturing the same, and a method for inspecting a reflective mask blank-related substrate according to the present invention, the case of the "surroundings of the reference mark forming region 41" being the main pattern forming region 50 is described, but even in the case of the "surroundings of the reference mark forming region 41" being regions other than the main pattern forming region 50, the same can be said about structures, procedures, effects and the like.

The reference mark forming region 41 is formed at a different height from the main pattern forming region 50, and thereby contrast is generated to inspection light in the reference mark forming region 41 and the surroundings thereof (main pattern forming region 50). For example, in FIG. 1, the reference mark forming region 41 is a lower region than the main pattern forming region 50, and in FIG. 2, the reference mark forming region 41 is a higher region than the main pattern forming region 50. In FIG. 2, a deposition layer 60 is formed between the multilayer reflective film 20 and the absorber film 30 so that the reference mark forming region 41 is in a protruded shape.

Though not illustrated in FIGS. 1 and 2, a protection film for preventing damage to the multilayer reflective film 20 during pattern formation to the absorber film 30 may be formed between the multilayer reflective film 20 and the absorber film 30. Further, a hard mask film that functions as an etching mask when dry-etching the absorber film 30 may be provided on the absorber film 30. Furthermore, a conductive film having a function as an antistatic layer during electrostatic chucking may be provided on a back surface side of the substrate 10. Furthermore, other functional layers may be provided.

Hereinafter, each part will be described using the mode in FIG. 1 as an example, but unless otherwise specified, the same applies to the mode in FIG. 2.

The substrate 10 preferably has low thermal expansion characteristics for use in EUV light exposure, and is preferably formed from, for example, a material whose thermal expansion coefficient is within a range of ±2 × 10⁻⁸/°C, and preferably in a range of ±5 × 10⁻⁹/°C. Further, the substrate 10 having a front surface sufficiently flattened is preferably used, and surface roughness of a main surface of the substrate 10 is 0.5 nm or less, and preferably 0.2 nm or less in particular, in terms of RMS value. The surface roughness like this can be obtained by polishing or the like of the substrate 10.

The multilayer reflective film 20 is generally a multilayer film made by alternately stacking a low-refractive index material and a high-refractive index material, and in this case, is a film that reflects EUV light that is exposure light. In the mode in FIG. 1, the multilayer reflective film 20 has a stacked layer portion 25 composed of multiple layers in which layers 21 having a relatively high refractive index with respect to EUV light and layers 22 having a relatively low refractive index with respect to EUV light are alternately stacked. In the stacked layer portion 25, for the layer 21 having a relatively high refractive index with respect to the EUV light, what is made by periodically stacking Si (silicon) is preferably used, and for the layer 22 having a relatively low refractive index with respect to the EUV light, what is made by periodically stacking Mo (molybdenum) is preferably used (in this case, the stacked layer portion 25 is an Si/Mo stacked layer portion). Here, the Si layer 21 and the Mo layer 22 may be respectively layers formed from elemental silicon and elemental molybdenum, or may contain other components. Furthermore, a diffusion prevention layer may be provided between the Si layer 21 and the Mo layer 22. The diffusion prevention layer may be provided entirely or may be provided partly, between the Si layers 21 and the Mo layers 22.

The multilayer reflective film 20 can be formed by, for example, an ion beam sputtering method or a magnetron sputtering method.

The Numbers of stacked Si layer 21 and Mo layer 22 are preferably, for example, 40 periods or more (40 layers or more for each), and are preferably 60 periods or less (60 layers or less for each).

Thicknesses of the Si layer 21 and the Mo layer 22 of the Si/Mo stacked layer portion 25 are properly set according to an exposure light wavelength, the thickness of the Si layer 21 is preferably 5 nm or less, and the thickness of the Mo layer 22 is preferably 4 nm or less. A lower limit of the thickness of the Si layer 21 is not particularly limited, but usually is 1 nm or more. A lower limit of the thickness of the Mo layer is not particularly limited, but is usually 1 nm or more. The thicknesses of the Si layer 21 and the Mo layer 22 can be set so that high reflectance can be obtained with respect to EUV light. Furthermore, each of the thicknesses of the Si layers 21 and the Mo layers 22 may be constant or may be different in individual layers. A thickness of the entire Si/Mo stacked layer portion 25 is usually about 250 to 450 nm.

Furthermore, the multilayer reflective film 20 may have a structure having an Si/Ru stacked layer portion 25 composed of multiple layers in which Si (silicon) layers 21 and Ru (ruthenium) layers 22 are alternately stacked.

There are no restrictions on the material of the absorber film 30 as long as it is a material that absorbs exposure light and enables pattern processing. As the material of the absorber film 30, a material containing tantalum (Ta) or chrome (Cr) is preferably used, for example. The material containing Ta or Cr may contain oxygen (O), nitrogen (N), carbon (C), boron (B) and the like. Examples of materials containing Ta include elemental Ta and tantalum compounds such as TaO, TaN, TaON, TaC, TaCN, TaCO, TaCON, TaB, TaOB, TaNB, TaONB, TaCB, TaCNB, TaCOB, and TaCONB. Examples of materials containing Cr include elemental Cr, and chrome compounds such as CrO, CrN, CrON, CrC, CrCN, CrCO, CrCON, CrB, CrOB, CrNB, CrONB, CrCB, CrCNB, CrCOB, and CrCONB. Further, a multilayer structure composed of these materials may be adopted. Furthermore, the absorber film 30 may function as a phase shift mask.

The absorber film 30 can be formed by, for example, an ion beam sputtering method, and a magnetron sputtering method.

Furthermore, as described above, a protection film may be formed between the multilayer reflective film 20 and the absorber film 30. The protection film is required to have a function of protecting the multilayer reflective film 20 from various kinds of dry etching and cleaning in a reflective mask production step, an exposure environment during use of the reflective mask, a cleaning process in a regeneration step after use, and the like, and a protection film containing additive elements such as ruthenium (Ru), niobium (Nb), zirconium (Zr), and titanium (Ti) and has resistance to various processes is preferably used, and may have a multilayer structure formed from these materials.

The protection film can be formed, for example, by an ion beam sputtering method, and a magnetron sputtering method.

On a side apart from the substrate 10, on the absorber film 30, a hard mask film (etching mask film of the absorber film 30) that is preferably in contact with the absorber film 30 and has different etching characteristics from the absorber film 30 may be provided. This hard mask film is a film that functions as an etching mask when dry-etching the absorber film 30. This hard mask film may be left as a reflectance reduction layer for reducing a reflectance in a wavelength of light used, for example, in inspection such as pattern inspection, to be made a part of the absorber film 30, or may be removed so as not to remain on the EUV reflective mask, after an absorber pattern is formed.

As a material of the hard mask film, a material containing, for example, chrome (Cr) is preferably used, and the hard mask film may have a multilayer structure. A hard mask film formed from a material containing Cr is preferable particularly when the absorber film 30 is formed from a material containing Ta but not Cr.

The hard mask film can be formed by, for example, a magnetron sputtering method.

There is no particular limit to a thickness of the hard mask film, but it is usually about 5 to 20 nm.

On the back surface side of the substrate 10, a conductive film may be provided as an antistatic layer during electrostatic chucking. The conductive film preferably has sheet resistance of 100 Ω/**□** or less, and there is no particular limit to the material. As the material of the conductive film, materials containing, for example, tantalum (Ta) or chrome (Cr) are preferably used. Further, the material containing Ta or Cr may contain oxygen (O), nitrogen (N), carbon (C), boron (B) and the like. Examples of the materials containing Ta include elemental Ta, and tantalum compounds such as TaO, TaN, TaON, TaC, TaCN, TaCO, TaCON, TaB, TaOB, TaNB, TaONB, TaCB, TaCNB, TaCOB, and TaCONB. Examples of materials containing Cr include elemental Cr, and chrome compounds such as CrO, CrN, CrON, CrC, CrCN, CrCO, CrCON, CrB, CrOB, CrNB, CrONB, CrCB, CrCNB, CrCOB, and CrCONB. Furthermore, the conductive film may have a multilayer structure formed from these materials.

There is no particular limit to a thickness of the conductive film, but is usually about 5 to 100 nm. The film thickness of the conductive film is preferably formed such that the multilayer reflective film 20 and the absorber pattern, and a film stress are well balanced after the absorber pattern is formed.

The conductive film may be formed before the multilayer reflective film 20 is formed, or may be formed after all films on the multilayer reflective film 20 side of the substrate 10 are formed, or after some films on the multilayer reflective film 20 side of the substrate 10 are formed, the conductive film may be formed, and thereafter, remaining films on the multilayer reflective film 20 of the substrate 10 may be formed.

The conductive film can be formed by, for example, an ion beam sputtering method, and a magnetron sputtering method.

Furthermore, the EUV reflective mask blank may be such that a resist film is formed on a side that is farthest from the substrate 10. The resist film is preferably an electron beam (EB) resist.

Next, the reference mark 40 and the reference mark forming region 41 will be described.

Here, first, the significance (meaning of the existence) of forming the reference mark forming region 41 will be explained again. A position of the reference mark 40 is identified by a defect inspection machine (for example, M8650 and ABICS Series E120 manufactured by Lasertec Corporation) during a reflective mask blank manufacturing process. However, when a defect exists around the reference mark 40, the defect has been erroneously detected as the reference mark 40. In such a case, the defect position in the coordinate system defined by the reference mark cannot be properly obtained, and in the manufacturing process of the reflective mask, DM technology cannot be used as a result of the defect position based on the reference mark 40 cannot be identified with high precision, which causes fatal abnormality to the pattern shape to be transferred onto a wafer.

On the other hand, when there is the reference mark forming region 41 as in the present invention, it is possible to distinguish a defect and the reference mark 40 based on presence or absence of the reference mark forming region 41 when searching for the reference mark 40 by the defect inspection machine. Accordingly, it is possible to accurately identify the defect position from the detected reference mark 40 without causing error detection as described above.

FIG. 3 shows an example of disposition of the reference mark 40 and the reference mark forming region 41 on the reflective mask blank. In FIG. 3, the reference marks 40 are disposed at four corners one by one on a surface on a same side as the multilayer reflective film 20 of the reflective mask blank 1, but three or more reference marks 40 that are not on a same straight line are preferably formed, and places where the reference marks 40 are formed and the number of reference marks 40 are not particularly limited. However, in order to prevent overlap with the main pattern in the EUV reflective mask, it is preferable to form them outside the main pattern forming region 50.

Note that explaining with reference to FIG. 3 in plan view, an example of the "surroundings of the reference mark forming region 41" at a different height from the reference mark forming region 41 can be the main pattern forming region 50 as described above, or can be a region other than the main pattern forming region 50 (region between the reference mark forming region 41 and the main pattern forming region 50, a region between the mutual reference mark forming regions 41, which is along an outer periphery of the reflective mask blank 1, or the like).

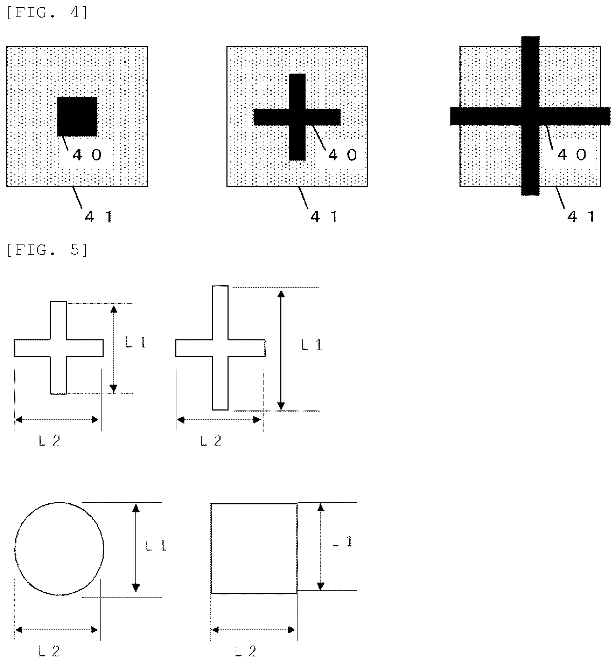

FIG. 4 shows an example of a mutual positional relationship of the reference mark 40 and the reference mark forming region 41 in the present invention. As described above, as shown in FIG. 4, the reference mark 40 is formed such that at least a part of the reference mark 40 is included in the reference mark forming region 41. A whole of the reference mark 40 may be included in the reference mark forming region 41 (a left figure and a center figure of FIG. 4), or only a part of the reference mark 40 may be included in the reference mark forming region 41 (a right figure in FIG. 4).

Since the reference mark 40 and the reference mark forming region 41 are in such a positional relationship, if the reference mark forming region 41 is detected during search for the reference mark 40, the reference mark 40 can be detected easily and reliably, and a defect and the reference mark 40 can be distinguished.

A recess and a protrusion of the reference mark 40 and the reference mark forming region 41 are not particularly limited, and they may be in a protruded shape or a recessed shape. Forming methods of the reference mark 40 and the reference mark forming region 41 are not particularly limited, and same forming methods may be used, or different forming methods may be used. However, since the reference mark 40 serves as a reference for a defect position, it is desirably formed by focused ion beam processing (hereinafter simply referred to as FIB) or lithography, which allows for high-precision processing. Note that the reference mark forming region 41 can also be formed by using a similar method. In FIB, FIB irradiation is performed for a target region, and thereby the irradiated region is etched, and can be formed in a recessed shape. On the other hand, by performing FIB irradiation while spraying compound gas to a sample surface during FIB irradiation, deposition is selectively applied to the irradiated region, and the irradiated region can be formed in a protruded shape. The latter is referred to as a deposition function of FIB. In FIG. 1, the reference mark 40 is formed by removing a part of the multilayer reflective film 20, but it may be formed by removing a whole of the multilayer reflective film 20, it may be formed by removing the substrate under it, or it may be formed on the other layer such as the substrate 10 or the absorber film 30. Further, it may be formed across a plurality of layers. When the reference mark 40 is formed in a protruded shape, the layer for forming it is not particularly limited. However, in order to make it serve as the reference position for a phase defect, it can be desirably used as the reference position in the defect inspection in the multilayer reflective film 20, and it is desirably formed on the substrate 10, the multilayer reflective film 20, or the protection film.

Furthermore, FIG. 5 shows shape examples (four) in plan view of the reference mark 40, but the shape of the reference mark in the present invention is not limited to them. As shown in FIG. 5, cross shapes, a circular shape, a rectangular shape or the like in plan view are conceivable, and it is desirable that longitudinal and lateral lengths (sizes) L1 and L2 thereof are 0.1 µm or more to prevent it from being too small and reducing visibility. Furthermore, when the reference mark 40 is formed by using FIB, the sizes are desirably 30 µm or less, and more desirably 10 µm or less, in order to prevent the sizes from being too large and causing a long time to process it.

Furthermore, a depth of the reference mark 40 is desirably 40 nm or more to prevent the depth from being too shallow and worsening contrast. Furthermore, when the reference mark 40 is formed by using FIB, the depth is more desirably 150 nm or less in order to prevent the reference mark from being too deep and causing a long time to process it. When the reference mark 40 is formed by FIB, a current value thereof is desirably 100 pA or less since contrast during detection is enhanced by increasing a side wall angle of the mark in the sectional shape.

As long as a recess or a protrusion of the reference mark forming region 41 is at a different height from the main pattern forming region 50 as described above, a depth (or a height) and a shape thereof are not particularly limited. When it is formed in a recessed shape, a depth is desirably 1 nm or more, and more desirably 3 nm or more because if the depth is too shallow, contrast from the surroundings is small during search for the reference mark 40 by a defect inspection machine, and presence or absence of the reference mark forming region 41 is difficult to determine. Further, when the reference mark forming region 41 is formed by FIB, the depth of the reference mark forming region 41 is desirably 10 nm or less, and more desirably 5 nm or less because if the depth is too deep, the processing time by FIB is too long, which causes reduction in throughput. Furthermore, when a height difference between the reference mark 40 and the reference mark forming region 41 is small, it causes reduction in contrast between both of them, and therefore, the height difference between the reference mark 40 and the reference mark forming region 41 is desirably 40 nm or more, and more desirably 70 nm or more.

Furthermore, when the reference mark forming region 41 is formed in a protruded shape, the height is desirably 1 nm or more and more desirably 3 nm or more, because if the height thereof is too low, contrast from the surroundings becomes small during search for the reference mark 40, which makes it difficult to determine presence or absence of the reference mark forming region 41. Furthermore, when the reference mark forming region 41 is formed by using the deposition function of FIB, the height of the reference mark forming region 41 is desirably 10 nm or less, and more desirably 5 nm or less, because if the height thereof is too high, the processing time by FIB is too long to cause reduction in throughput. Furthermore, when the height difference between the reference mark 40 and the reference mark forming region 41 is small, it causes reduction in contrast between both of them, and therefore, the height difference between the reference mark 40 and the reference mark forming region 41 is desirably 40 nm or more, and more desirably 70 nm or more.

As above, an absolute value of the height difference between the reference mark forming region 41 and the main pattern forming region can be particularly 1 nm or more, and even 3 nm or more, and can be 10 nm or less, and even 5 nm or less in order to more reliably create contrast between the reference mark forming region 41 and the surroundings thereof (main pattern forming region 50). Furthermore, the absolute value of the height difference between the reference mark 40 and the reference mark forming region 41 can be 40 nm or more, and even 70 nm or more so that contrast between both of them is reliably created.

Further, a plan view shape of the reference mark forming region 41 is not particularly limited and can be formed in a rectangular shape as shown in FIG. 4, or other polygonal shapes, a circular shape and the like.

As repeatedly described, the reference mark forming region 41 is used to distinguish between a defect and the reference mark 40 based on presence or absence of the reference mark forming region 41 when searching for the reference mark 40 by a defect inspection machine. For example, when inspection is performed for a region around the reference mark 40, an optical image is obtained at coordinates where a certain level or more of signal intensity is output, and existence of the reference mark forming region 41 can be confirmed in the optical image, it can be determined as the reference mark 40, and when existence of the reference mark forming region 41 cannot be confirmed, it can be determined as a defect.

Therefore, it is desirable that the size in plan view of the reference mark forming region 41 is smaller than a field of view of the optical image obtained by the defect inspection machine. In this case, it is convenient because a boundary of the reference mark forming region 41 can be displayed within the field of view more reliably, and presence or absence thereof is determined much more easily. Accordingly, it is desirable that the size of the reference mark forming region 41 is 30 µm or less, and it is more desirable that the size thereof is 10 µm or less. On the other hand, in order to prevent the size of the reference mark forming region 41 from being too small and making it difficult to determine the presence or absence thereof, the size is desirably 1 µm or more, and more desirably 5 µm or more. By forming the reference mark forming region 41 of such a size, search for the reference mark forming region 41, and thus distinguishment between a defect and the reference mark 40 are much easier, and a risk of erroneous detection can be further reduced.

Next, the manufacturing method of the present invention for manufacturing the reflective mask blank of the present invention as shown in FIGS. 1 and 2 will be described.

First, as main steps, at least a step of forming the multilayer reflective film 20 on the substrate 10, and a step of forming the absorber film 30 on the multilayer reflective film 20 are included. As necessary, the other functional layers such as the protection film, the hard mask film, the conductive film, and the resist film described above can also be formed. Forming methods of these respective films are not particularly limited, and the respective films can be formed in the same manner as in the conventional methods (an ion beam sputtering method, a magnetron sputtering method, and the like) by using, for example, the materials described above.

Furthermore, steps of forming the reference mark 40 and the reference mark forming region 41 on the surface on the same side as the multilayer reflective film 20 are included.

Note that the reference mark 40 is preferably formed on the substrate 10, the multilayer reflective film 20, or the protection film as described above. It can be formed with high precision by, for example, FIB processing or lithography after the substrate is prepared, or after these films are formed.

The reference mark forming region 41 can be formed by, for example, FIB processing.

By setting the size of the intended reference mark forming region 41 and performing FIB irradiation, the irradiated region is etched by FIB, and becomes deeper as compared to the region not irradiated. The depth can be changed arbitrarily by changing scanning conditions.

Further, by performing FIB irradiation while spraying compound gas onto a sample surface during FIB irradiation, deposition can be selectively performed on the irradiated region (formation of the deposition layer 60). Thereby, the irradiated region becomes higher as compared to the region not irradiated. The height can be arbitrarily changed by changing the scanning conditions and gas pressure.

In this way, the reference mark forming region 41 is formed so as to have a recessed shape or a protruded shape with a different height from the main pattern forming region 50. Note that at this time, the reference mark 40 is formed such that at least a part of the reference mark 40 is included in the reference mark forming region 41.

Further, the reference mark forming region 41 may be produced before producing the reference mark 40 or may be produced after the reference mark 40 is produced. When acquiring a scanning ion microscope (SIM) image and a scanning electron microscope (SEM) image to confirm the shape of the reference mark 40 after the reference mark 40 is produced, scan marks that are protruded or recessed relative to surroundings thereof are generated in the scan region due to the sputtering effect caused by irradiating the scan region with ion beam or electron beam, or due to contamination. The scan marks may be used as the reference mark forming region 41.

Note that it is desirable to form the reference mark forming region 41 centered on central coordinates of the reference mark 40. In doing so, even if a defect having substantially a same size as the reference mark 40 exists inside the reference mark forming region 41, the defect and the reference mark 40 can be distinguished based on a positional relationship with the reference mark forming region 41.

In addition, the preferred modes of the absolute value of the height difference from the main pattern forming region 50 when forming the reference mark forming region 41, and the size compared to the field of view of the optical image obtained by the defect inspection machine are as described above.

Next, an inspection method of a reflective mask blank-related substrate of the present invention will be described.

As main steps, an inspection object preparation step of preparing a reflective mask blank-related substrate to be inspected, and an inspection step including search for a reference mark (formed on a surface on a same side as a multilayer reflective film in a reflective mask blank product) formed on the prepared reflective mask blank-related substrate, and identification of a defect position based on the reference mark are included.

In the inspection object preparation step, a reflective mask blank-related substrate, for example, the reflective mask blank 1 of the present invention as shown in FIG. 1 or 2 described above is prepared. Alternatively, a manufacturing intermediate thereof may be prepared. As the manufacturing intermediate, a substrate with a thin film having at least one layer composing the reflective mask blank 1 can be prepared. More specifically, a substrate in a state in which only the multilayer reflective film 20 is formed thereon, or a substrate in a state in which the absorber film 30 is further formed thereon can be prepared. Alternatively, a substrate in a state in which the protection film, hard mask film, conductive film, and resist film that are described above, the other functional layers, and the like are properly formed thereon can be prepared. Here, the inspection method will be described with the case in which the reflective mask blank 1 of the present invention is prepared will be described as an example.

Furthermore, in the inspection step, during search for the reference mark 40, the reference mark 40 and a defect are distinguished based on presence or absence of the reference mark forming region 41. By using the presence or absence of the reference mark forming region 41, the defect can be prevented from being erroneously detected as the reference mark 40. Accordingly, detection of the reference mark 40 can be ensured, and therefore the defect position can be properly identified based thereon.

Note that in the inspection step, not only detection position information based on the reference mark, but also necessary information such as the size, the recess and protrusion of the identified defect can be properly acquired.

### EXAMPLE

Hereinafter, the present invention will be specifically described with reference to an Example and Comparative Examples. However, the present invention is not limited thereto.

### (Example 1)

The multilayer reflective film 20 was formed on the substrate 10 formed of quartz glass measuring 152 mm square and 6.35 mm thick, by DC pulse magnetron sputtering using a molybdenum (Mo) target and a silicon (Si) target, with both the targets and the main surface of the substrate 10 facing each other, while the substrate 10 was rotated on its axis.

The respective targets were attached to a sputtering apparatus capable of mounting two targets and discharging electricity to the targets one by one or both simultaneously, and the substrate 10 was placed thereon. First, power was applied to the silicon (Si) target while argon (Ar) gas was flown into a chamber to form a silicon (Si) layer having a thickness of 4 nm, and application of the power to the silicon (Si) target was stopped. Subsequently, power is applied to the molybdenum (Mo) target while argon (Ar) gas was flown into the chamber to form a molybdenum (Mo) layer having a thickness of 3 nm, and application of the power to the molybdenum (Mo) target was stopped. The operation of forming the silicon (Si) layer and the molybdenum (Mo) layer constituted one cycle, and this cycle was repeated 40 times to form the multilayer reflective film 20.

Next, a protection film in contact with the multilayer reflective film 20 was formed on the multilayer reflective film 20 by DC pulse magnetron sputtering using an Ru target, with the Ru target facing the main surface of the substrate 10, while the substrate 10 being rotated on its axis.

Next, by irradiating a predetermined part of the protection film with FIB, all of the protection film and a part of the multilayer reflective film 20 of the irradiated part were removed, and the reference mark 40 having a rectangular shape with a width (lateral width) of 1 µm and a length (longitudinal width) of 1 µm in plan view was formed. Thereafter, a region having a width of 5 µm and a length of 5µm and centered on the reference mark 40 was scanned, and an SIM image of the reference mark 40 was obtained, and the reference mark forming region 41 was formed. At this time, the current value of FIB when producing the reference mark 40 and the reference mark forming region 41 was 50 pA. When the area around the reference mark 40 was observed by an atomic force microscope (AFM), the depth of the reference mark 40 was 100 nm, and the depth of the reference mark forming region 41 was 1.6 nm (that is, 1.6 nm deeper than the height position of the main pattern forming region).

Next, the protection film surface was inspected by the defect inspection machine (M8650 manufactured by Lasertec Corporation), and the position of the reference mark 40 and the defect position on the protection film surface were obtained. When searching for the reference mark 40, the rectangle having a width of 1 mm and a length of 1 mm and centered on the design coordinates of the reference mark 40 was inspected as the inspection region, and coordinates of all defects that were determined to be 0.5 µm or more in size were extracted. Thereafter, the optical image obtained during inspection was referred to, and a defect and the reference mark 40 were distinguished based on presence or absence of the reference mark forming region 41, and the coordinates of the reference mark 40 were selectively obtained. The field of view of the optical image was substantially 30 µm (that is, the reference mark forming region 41 having a size of 5 µm × 5 µm is smaller than the above-described field of view).

Next, the absorber film 30 in contact with the protection film was formed on the protection film by DC pulse magnetron sputtering using a Ta target, with the Ta target and the main surface of the substrate 10 facing each other, while the substrate 10 was rotated on its axis.

Next, the surface of the absorber film 30 was inspected by the defect inspection machine (M8650 manufactured by Lasertec Corporation), and the position of the reference mark 40 and the defect position on the surface of the absorber film 30 were obtained. When searching for the reference mark 40, a rectangle having a width of 1 mm and a length of 1 mm and centered on the design coordinates of the reference mark 40 was inspected as the inspection region, and the coordinates of all the defects determined to have a size of 0.5 µm or more were extracted. Thereafter, the optical image obtained during inspection was referred to, and the defects and the reference mark 40 were distinguished based on presence or absence of the reference mark forming region 41, and the coordinates of the reference mark 40 were selectively obtained. The field of view of the optical image was approximately 30 µm.

Next, the hard mask film in contact with the absorber film 30 was formed on the absorber film 30 by DC pulse magnetron sputtering using a Cr target, with the Cr target and the main surface of the substrate 10 facing each other, while the substrate 10 was rotated on its axis, and the EUV reflective mask blank was produced.

Next, the surface of the hard mask film was inspected by the defect inspection machine (M8650 manufactured by Lasertec Corporation), and the position of the reference mark 40 and the defect position on the hard mask film surface were obtained. When searching for the reference mark 40, the rectangle having a width of 1 mm and a length of 1 mm and centered on the design coordinates of the reference mark 40 was inspected as the inspection region, and the coordinates of all defects determined to have a size of 0.5 µm or more were extracted. Thereafter, the optical image obtained during inspection was referred to, the defect and the reference mark 40 were distinguished based on presence or absence of the reference mark forming region 41, and the coordinates of the reference mark 40 were selectively obtained. The field of view of the optical image was approximately 30 µm.

Incidentally, in Example 1 described above, the main pattern forming region was set as the "surroundings of the reference mark forming region". However, even when the region other than the main pattern forming region was set, the similar result was able to be obtained. Specifically, even when the region between the reference mark forming region and the main pattern forming region, and the region between the mutual reference mark forming regions, which is along the outer periphery of the reflective mask blank were set as the "surroundings of the reference mark forming region", the defects and the reference marks were able to be distinguished and the coordinates of the reference marks were able to be obtained selectively, as in Example 1.

As above, according to the reflective mask blank and the method for manufacturing the same, and the method for inspecting a reflective mask blank-related substrate of the present invention, it becomes easy to distinguish the reference mark 40 and a defect based on presence or absence of the reference mark forming region 41, and it is possible to reliably detect the reference mark 40 without erroneously recognizing the defect as the reference mark 40 in the reflective mask blank, in search for the reference mark 40 by the defect inspection machine.

It should be noted that the present invention is not limited to the above-described embodiment. The embodiment is just an example, and any examples that substantially have the same feature and demonstrate the same functions and effects as those in the technical concept disclosed in claims of the present invention are included in the technical scope of the present invention.

## Claims

1. A reflective mask blank comprising at least:
a substrate;
a multilayer reflective film provided on the substrate, the multilayer reflective film reflecting exposure light; and
an absorber film provided on the multilayer reflective film, the absorber film absorbing the exposure light,
the reflective mask blank further comprising:
a reference mark serving as a reference position for a defect position; and a reference mark forming region for searching for the reference mark, the reference mark and the reference mark forming region being formed on a surface on a same side as the multilayer reflective film of the reflective mask blank,
the reference mark forming region being formed at a different height from surroundings of the reference mark forming region or from a main pattern forming region,
the reference mark being formed such that at least a part of the reference mark is included in the reference mark forming region.

2. The reflective mask blank according to claim 1, wherein the reference mark forming region is formed at a different height from a main pattern forming region, and wherein an absolute value of a height difference between the reference mark forming region and the main pattern forming region is 1 nm or more.

3. The reflective mask blank according to claim 1 or claim 2, wherein the reference mark forming region is formed at a different height from a main pattern forming region, and wherein the reference mark forming region is smaller than a field of view of an optical image obtained by a defect inspection machine used during search for the reference mark.

4. A method for manufacturing a reflective mask blank, comprising at least steps of:
forming a multilayer reflective film on a substrate, the multilayer reflective film reflecting exposure light; and
forming an absorber film on the multilayer reflective film, the absorber film absorbing the exposure light;
the method further comprising
a step of forming a reference mark and a reference mark forming region on a surface on a same side as the multilayer reflective film of the reflective mask blank, the reference mark serving as a reference position for a defect position, the reference mark forming region being for searching for the reference mark,
wherein in the step of forming the reference mark and the reference mark forming region,
the reference mark forming region is formed to have a different height from surroundings of the reference mark forming region or from a main pattern forming region, and
the reference mark is formed such that at least a part of the reference mark is included in the reference mark forming region.

5. The method for manufacturing a reflective mask blank according to claim 4,
wherein in the step of forming the reference mark and the reference mark forming region,
the reference mark forming region is formed to have a different height from a main pattern forming region, and the reference mark forming region is formed such that an absolute value of a height difference between the reference mark forming region and the main pattern forming region is 1 nm or more.

6. The method for manufacturing a reflective mask blank according to claim 4 or claim 5,
wherein in the step of forming the reference mark and the reference mark forming region,
the reference mark forming region is formed to have a different height from a main pattern forming region, and the reference mark forming region is formed to be smaller than a field of view of an optical image obtained by a defect inspection machine used during search for the reference mark.

7. The method for manufacturing a reflective mask blank according to any one of claims 4 to 6,
wherein in the step of forming the reference mark and the reference mark forming region,
the reference mark forming region is formed to have a different height from a main pattern forming region, and wherein when forming the reference mark and the reference mark forming region, the reference mark and the reference mark forming region are formed by FIB processing.

8. A method for inspecting a reflective mask blank-related substrate, the reflective mask blank-related substrate being selected from a reflective mask blank and a manufacturing intermediate of the reflective mask blank, the reflective mask blank comprising at least:
a substrate;
a multilayer reflective film provided on the substrate, the multilayer reflective film reflecting exposure light; and
an absorber film provided on the multilayer reflective film, the absorber film absorbing the exposure light,
the method comprising:
an inspection object preparation step of preparing the reflective mask blank-related substrate to be inspected; and
an inspection step including search for a reference mark formed on the prepared reflective mask blank-related substrate, and identification of a defect position based on the reference mark,
wherein in the inspection object preparation step,
as the reflective mask blank-related substrate to be inspected, a reflective mask blank-related substrate is prepared, the reflective mask blank-related substrate comprising the reference mark and a reference mark forming region, the reference mark serving as a reference position for the defect position, the reference mark forming region being for searching for the reference mark, the reference mark and the reference mark forming region being formed on a surface on a same side as the multilayer reflective film of the reflective mask blank,
the reference mark forming region being formed at a different height from surroundings of the reference mark forming region or from a main pattern forming region,
the reference mark being formed such that at least a part of the reference mark is included in the reference mark forming region, and
wherein in the inspection step,
during the search for the reference mark, the reference mark and a defect are distinguished based on presence or absence of the reference mark forming region.
